# FASCICULE DE BREVET EUROPEEN

(11) **EP 0 880 228 B1**
(45) Date de publication et mention de la délivrance du brevet: **27.11.2002**
(21) Numéro de dépôt: 98401201.3
(22) Date de dépôt: 19.05.1998
(51) Int. Cl.: H03K 17/10, H03K 17/12

(54) **Interrupteur rapide, capable de supporter une tension et un courant directs élevés, obtenu par assemblage de thyristors élémentaires**
Schneller, als Anordnung elementarer Thyristoren realisierter Schalter mit hoher Gleichspannungs- und Gleichstromfestigkeit
Fast switch able to withstand high DC voltage and current, realized by assembly of elementary thyristors

(30) Priorité: 21.05.1997 FR 9706176
(43) Date de publication de la demande: 25.11.1998
(73) Titulaire: COMMISSARIAT A L'ENERGIE ATOMIQUE, 75015 Paris Cédex 15 (FR); COMPAGNIE GENERALE DES MATIERES NUCLEAIRES, 78140 Velizy Villacoublay (FR)
(72) Inventeur: Chatroux, Daniel, 26200 Montelimar (FR); Regnard, Philippe, 84500 Bollène (FR); Rigole, Hervé, 38090 Villefontaine (FR)
(74) Mandataire: Moutard, Pascal Jean

(56) Documents cités:
- EP-A- 0 227 407
- EP-A- 0 395 801
- DE-C- 4 217 234

## Description

### Domaine technique et art antérieur

L'invention concerne un interrupteur rapide, pouvant supporter une tension et un courant direct élevés. Un tel interrupteur est obtenu par assemblage de thyristors élémentaires.

L'invention s'applique aux commutateurs solides rapides, de type impulsionnels. Elle d'applique en particulier aux commutateurs solides rapides pour des impulsions de durée comprises sensiblement entre une microseconde et une milliseconde, sous haute tension (>1kV), à fort courant (>1kA), avec un dI/dt élevé.

L'invention concerne donc également les commutateurs solides, rapides, impulsionnels. De tels commutateurs sont par exemple utilisés comme interrupteurs pour des alimentations impulsionnelles de lasers(pour des impulsions pouvant avoir les caractéristiques suivantes : 20kV, 1kA, durée de l'ordre de la microseconde). Ils sont aussi utilisés comme "crowbar" ou, de manière plus générale, comme interrupteurs de courants très forts (par exemple de caractéristiques : 50kV, 1-10kA, 100-200 µs).

Le crowbar est un court-circuiteur destiné à protéger les biens et les personnes de la haute tension. En cas de problème, il court-circuite très rapidement la haute tension, décharge les condensateurs de stockage d'énergie, protège les équipements et les personnes situés en aval le temps qu'une protection amont fonctionne. Il s'agit d'un mode classique de protection en haute tension. En basse tension, la protection est assurée par ouverture de circuit, en haute tension la sécurité consiste d'abord à court-circuiter et à décharger toute l'énergie stockée.

Le thyristor est un composant bien adapté à ce type d'application. En effet, grâce à sa structure en quatre couches, il accepte des densités de courant élevées. Il n'y a pas d'auto-limitation en courant comme pour les MOS, IGBT et transistors bipolaires. Un thyristor conducteur peut accepter des courants impulsionnels bien supérieurs à son courant nominal pendant des temps relativement longs.

De plus, du fait de sa structure, le thyristor possède une très bonne tenue en tension, car il autorise une zone N- épaisse, qui assure la tenue en tension. Il est capable de moduler très fortement sa résistivité par injection d'électrons et de trous pour assurer une résistance faible à l'état passant.

Le problème des thyristors vient de leurs faibles dI/dt. Une gâchette permet l'amorçage du composant. Lorsqu'un courant positif est envoyé dans la gâchette, la conduction s'effectue au voisinage de celle-ci puis s'étend progressivement sur toute la surface. Ainsi, la vitesse de croissance du courant de puissance doit être limitée (spécification donnée par le constructeur). Dans le cas contraire, le passage en force du courant provoque un échauffement local brutal pouvant détruire le thyristor.

Actuellement, on connaît des interrupteurs rapides mettant en oeuvre des thyristors de grandes tailles à fort dI/dt, éventuellement mis en série. Ces thyristors sont dotés de dispositifs ayant pour but d'augmenter la rapidité de leurs mises en conduction.

Par exemple, l'article de J. Vitins et al. Intitulé "Reverse conducting thyristors replace thyratrons in sub-microsecond pulse generation", paru dans Digest of Technical Papers, Sixth IEEE pulsed Power Conference, 1987, Arlington, Virginia, décrit un thyristor à gâchette interdigitée. La gâchette est en forme d'étoile ou de flocon. Le comportement à l'amorçage (du point de vue de l'extension du plasma) est nettement supérieur aux thyristors à gâchette centrale.

Un thyristor à conduction inverse RCT (Reverse Conduction Thyristor) a une diode rapide antiparallèle intégrée au boîtier; Le courant peut ainsi circuler dans les deux sens. Ce procédé élimine les pertes par de conduction inverse, ainsi que la tension inverse qui peut s'avérer destructrice. Un tel dispositif est par exemple décrit dans l'article de G.R. Dreifuerst et al. intitulé "Development and operation of a solid-state switch for thyratron replacement" paru dans Digest of Technical Papers, Eighth IEEE International Pulsed Power Conférence, 1991, San Diego, California.

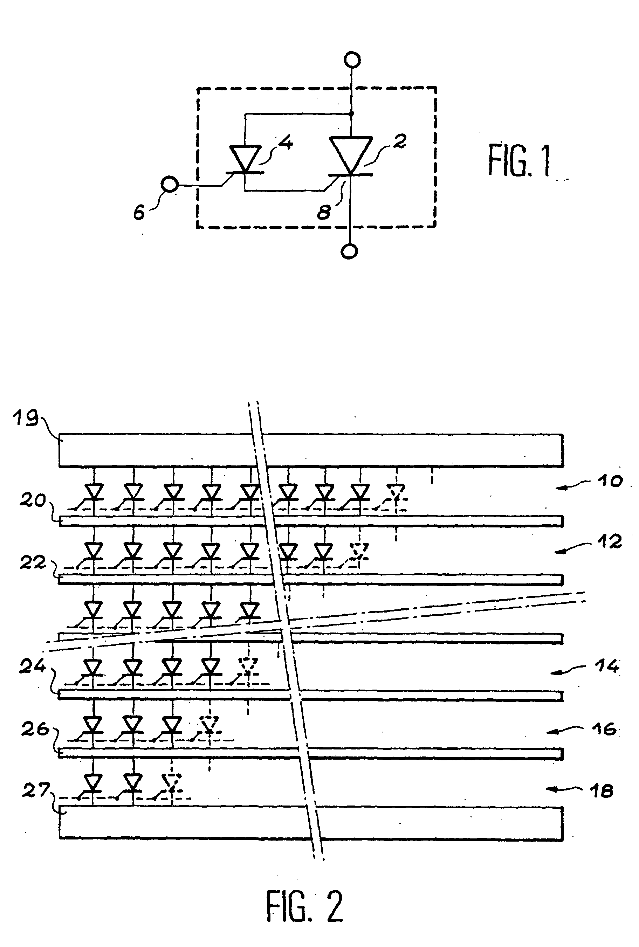

Une autre solution, pour accroître le dI/dt, est l'utilisation d'une gâchette amplificatrice. Ce type de dispositif est illustré sur la figure 1 et comporte deux thyristors, un thyristor de commande 4 et un thyristor principal 2, commandés respectivement par une gâchette 6, 8. Le courant d'anode du premier thyristor 4 sert de courant de déclenchement au second thyristor 2. Ainsi l'extension du plasma est très rapide du fait du courant de gâchette élevé. Ce dispositif autorise donc des dI/dt plus importants.

Une autre solution connue pour pouvoir utiliser le thyristor dans l'application de commutation de fort courant rapide, consiste à lui associer une self saturable en série. Elle se comporte comme un interrupteur magnétique et a pour rôle de retarder l'impulsion de courant. Lorsque le thyristor se met en conduction, la tension entre anode et cathode chute. La tension du montage est appliquée à la self saturable qui limite la vitesse de croissance du courant dans le thyristor. Au moment où la self se sature, le composant est suffisamment conducteur pour accepter l'impulsion de courant sans engendrer de fortes pertes de commutations. Il est à noter que les solutions déjà décrites ci-dessus sont souvent associées à une self saturable.

### Exposé de l'invention

Un des buts de l'invention est de réaliser un nouvel interrupteur rapide à thyristors, - en particulier pour courant fort, haute tension, acceptant des grands dI/dt - pouvant être réalisé avec des composants standards.

Par ailleurs, la réalisation d'un tel dispositif doit être compatible avec des contraintes industrielles de réalisation à coûts peu élevés.

Enfin, un tel dispositif doit de préférence pouvoir être réalisé sans composants d'équilibrage, au niveau courant (donc sans besoin d'une self en série) et/ou au niveau tension (donc sans besoin de résistances de répartition de tension).

L'invention a plus précisément pour objet un interrupteur de courant, comportant une matrice de thyristors élémentaires présentant chacun une gâchette de commande, cette matrice comprenant une pluralité d'étages montés en série, chaque étage comprenant une pluralité desdits thyristors montés en parallèle, les anodes des thyristors d'un même étage étant reliées entre elles et les cathodes des thyristors d'un même étage étant reliées entre elles.

Un tel interrupteur peut être réalisé à l'aide de thyristors élémentaires, par exemple des petits thyristors standards, de courant moyen inférieur à 30 ampères.

De plus, l'interrupteur selon l'invention est compatible avec une réalisation collective. En particulier, il peut être réalisé sous la forme de circuits imprimés, rendant l'ensemble compact et peu cher. En effet, la technologie de réalisation de composants électroniques sur circuit imprimé est très industrielle et peu coûteuse par rapport à une réalisation utilisant des pièces mécaniques spécifiques.

Dans la matrice mise en oeuvre dans l'interrupteur de courant selon l'invention, il n'y a pas de différence de potentiel entre les thyristors d'un même étage, disposés en parallèle, car leur cathode et leur anode sont reliées entre elles. Ainsi, on évite la nécessité de composants d'équilibrage de la tension.

Selon un aspect particulier de l'invention, des moyens peuvent être prévus pour délivrer un courant crête de gâchette de chaque thyristor supérieur au 1/3 du courant nominal moyen dans le thyristor. Ceci permet d'avoir une commande du dispositif fournissant un fort courant initial. Ainsi, on minimise la dispersion du temps de misé en conduction des différents thyristors.

Selon un autre aspect, les étages des thyristors sont reliés entre eux par des pistes électriquement conductrices. De préférence, la largeur de ces pistes est au moins égale à 4 mm : ceci permet d'éviter tout échauffement lors du passage d'un courant important, mais aussi d'éliminer les inductances parasites de connexion et de contribuer à un bon équilibrage des courants.

Le premier et le dernier étages des thyristors sont également reliés chacun à une piste électriquement conductrice. De préférence, ces pistes ont une largeur au moins égale à 10 mm : ceci permet d'obtenir un courant le plus uniforme possible entre chaque branche en parallèle, et donc de diminuer l'impédance des connexions.

Selon un autre aspect, l'interrupteur laissant passer les impulsions de courant ayant une certaine direction, dites positives, peut comporter également des moyens pour bloquer des impulsions de courant circulant sur une direction opposée, dite négative. Par exemple, la matrice de thyristor peut être connectée en série avec une diode.

Selon encore un autre aspect de l'invention, l'interrupteur comporte en outre des moyens pour laisser passer des impulsions de courant dites négatives. Ainsi, une diode peut être montée en parallèle et en inverse par rapport à la matrice de thyristor. On peut également munir chaque thyristor de la matrice d'une diode montée en parallèle et en inverse par rapport à ce thyristor.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- la figure 1 représente un interrupteur rapide selon l'art antérieur,
- la figure 2 est un schéma d'une matrice de thyristor d'un interrupteur de courant selon l'invention,
- les figures 3A et 3B représentent l'évolution temporelle de la tension et du courant d'une impulsion d'attaque d'une gâchette de thyristor, selon l'art antérieur et selon l'invention,
- la figure 4 est un exemple de schéma de commande rapide d'un interrupteur selon l'invention,
- la figure 5 représente une matrice de thyristor d'un interrupteur selon l'invention, montée en série avec une diode,
- la figure 6 représente une matrice de thyristor d'un interrupteur selon l'invention, montée en parallèle et en inverse avec une diode,
- la figure 7 est un autre exemple de réalisation d'un interrupteur selon l'invention.

### Description détaillée de modes de réalisation de l'invention

La figure 2 représente une matrice de thyristor d'un interrupteur selon l'invention. Cette matrice comporte plusieurs étages 10, 12, 14, 16, 18 de thyristors montés en série. Dans chaque étage, les différents thyristors sont montés en parallèle, leurs cathodes étant reliées entre elles du point de vue électrique, ainsi que leurs anodes.

Pour effectuer ces liaisons, les étages de thyristors peuvent être reliés entre eux par des pistes conductrices 20, 22, 24, 26. Les étages 10, 18 d'extrémité sont reliés à une piste supérieure 19 et à une piste inférieure 27, également conductrices.

Les thyristors d'un même étage étant montés en parallèle et étant reliés entre eux par leur cathode et leur anode, il n'y a pas de différence de potentiel entre eux, à la différence d'une structure dans laquelle les thyristors sont montés en parallèle, mais ne sont pas reliés entre eux, et possèdent des selfs d'aide à la commutation.

La matrice de thyristor selon l'invention peut être réalisée sur un circuit imprimé. En particulier, les pistes 20, 22, 24, 26 peuvent être des pistes de cuivre. De préférence, de telles pistes ont une largeur minimum de 4 mm, pour éviter tout échauffement lors du passage d'un courant important et pour diminuer les inductances parasites de connexion. Ceci contribue à un bon équilibrage des courants.

De même, les bandes 19, 27 d'entrée et de sortie de la matrice sont par exemple des bandes de cuivre, de largeur de préférence supérieure à 10 mm : une telle largeur permet d'avoir le courant le plus uniforme possible entre chaque branche en parallèle, et donc de diminuer l'impédance de connexion.

La structure qui vient d'être décrite peut être réalisée avec de petits thyristors standards, de courant moyen inférieur à 30 ampères, ne nécessitant pas de moyen d'équilibrage particulier. Ces thyristors ont l'avantage d'être peu coûteux par rapport à la puissance commutée (actuellement, de l'ordre de 7 francs pour des caractéristiques de commutation allant de 100 ampères sous 1 kV à 1kA sous 1kV).

Les performances de ces petits thyristors standards, du point de vue du dI/dt, sont approximativement comprises entre 100 A/µs et 1kA/µs suivant la commande d'attaque de gâchette choisie. On peut donc obtenir une impulsion ayant un dI/dt compris entre 3kA/µs et 30kA/µs en plaçant 30 thyristors en parallèle, sans self d'aide à la commutation.

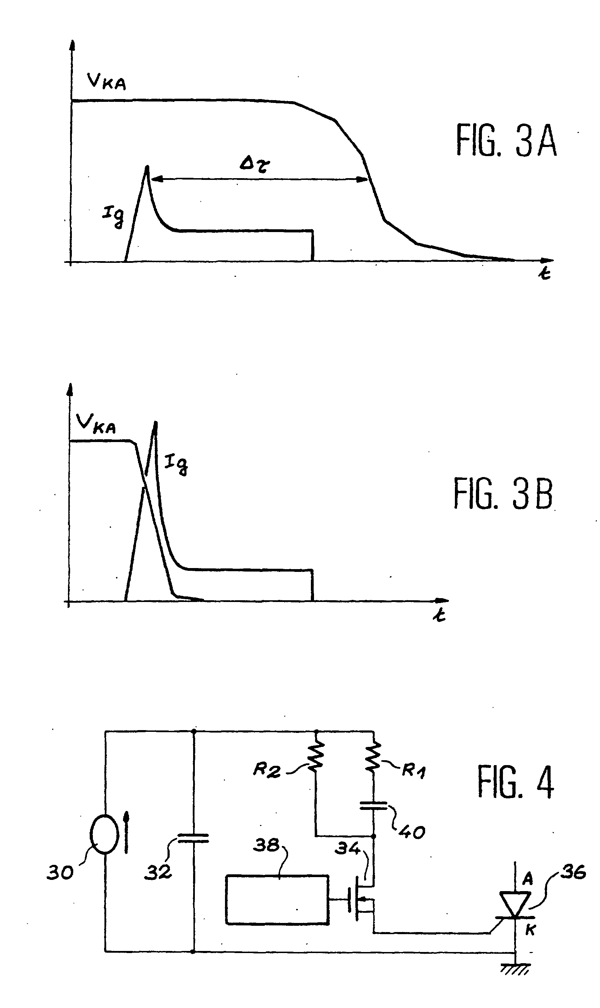

De préférence, la matrice de thyristor est attaquée à l'aide d'une commande rapide et énergique. En effet, une commande classique, correspondant au courant spécifié par le constructeur, peut entraîner une dispersion sur le temps de mise en conduction du thyristor : ceci est illustré sur la figure 3A, où la chute de tension V_{KA} aux bornes du thyristor s'effectue avec un certain retard Δτ par rapport au courant I_{g}. Il y a alors le risque que celui-ci passe à travers un seul des thyristors de la matrice, à savoir celui qui conduit en premier. On cherche donc à réaliser une attaque de gâchette ayant la forme illustrée sur la figure 33 : l'impulsion de courant I_{g} correspond à la chute de la tension V_{KA} entre la cathode et l'anode.

A cette fin, on peut utiliser le dispositif de commande rapide illustré sur la figure 4. Un tel dispositif comporte un transistor MOS 34 dont la source est reliée à la gâchette d'un thyristor 36. La grille du transistor MOS est reliée à un dispositif 38 de commande de grille. Le drain du transistor MOS est relié à une capacité 40 en série avec une résistance R₁. Ces deux derniers éléments sont montés en parallèle avec une résistance R₂. L'ensemble est monté lui-même en parallèle avec une capacité 32 et est alimenté par une source de tension 30. A titre d'exemple, un tel dispositif a été réalisé dans lequel la source de tension 30 alimente le dispositif sous 15V, et les capacités 40 et 32 valent respectivement 1µF et 4µF, les résistances R1 et R2 valant respectivement 1Ω et 22Ω. Le transistor MOS est de type MTP 3055 et le thyristor est du type TYN 1012.

Avec ce dispositif, les performances suivantes ont été atteintes :
- courant de gâchette crête : 5A,
- chute de V_{KA} en 50ns,
- courant moyen nominal dans le thyristor : 7A (donc impulsion de 100 à 1000A).

Pour assurer la mise en conduction du thyristor 36, le circuit de commande 38 génère une tension positive entre grille et source du MOS 34 pour rendre celui-ci conducteur. Le courant de charge de la capacité 40 traversant la résistance R₁ et la gâchette du thyristor permet d'assurer un courant de gâchette initial élevé supérieur au tiers du courant nominal du thyristor. Ainsi, la chute de la tension V_{AK} s'effectue sans retard.

Le courant traversant R₂, le MOS 34 et la gâchette du thyristor permet d'assurer un courant de gâchette permanent qui maintient le thyristor conducteur indépendamment de la présence ou non d'un courant principal entre l'anode et la cathode.

La commande ainsi réalisée permet de minimiser la dispersion du temps de mise en conduction, du fait de la forte injection de courant dans la gâchette. Il a été constaté qu'une commande énergétique convenable est obtenue lorsque le courant crête de gâchette est supérieur au tiers du courant nominal moyen dans le thyristor.

En général, un commutateur ou interrupteur à courant fort est placé dans un circuit non parfaitement amorti. Dans ce cas, le courant est oscillant et une impulsion de courant positive traversant les thyristors est suivie d'une impulsion négative.

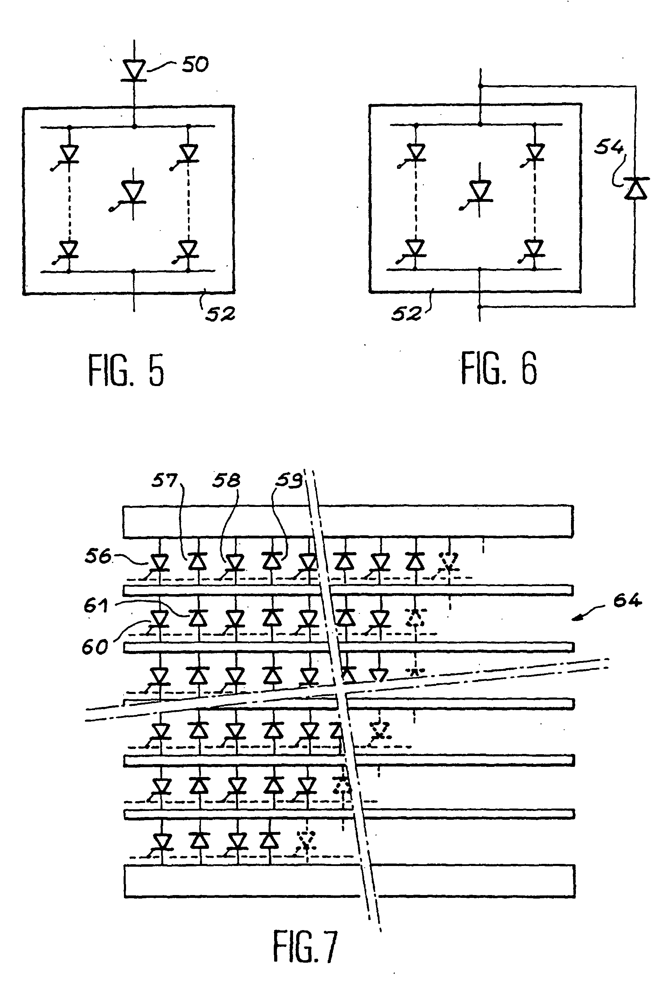

On peut bloquer une telle impulsion négative par une diode 50 (ou assemblage de diodes) montée en série avec une matrice de thyristor 52 selon l'invention, comme illustré sur la figure 5.

On peut également, comme illustré sur la figure 6, laisser passer le courant négatif par une diode 54 (ou un assemblage de diodes) montée en parallèle à la matrice de thyristor selon l'invention, et en inverse par rapport à celle-ci.

Selon un autre aspect de l'invention, on peut réaliser une matrice de thyristor 64 telle que déjà décrite ci-dessus, mais dans laquelle chaque thyristor 56, 58, 60, ... est muni d'une diode 57, 59, 61, ... montée en parallèle et en inverse par rapport au thyristor correspondant : ce mode de réalisation est illustré sur la figure 7.

## Revendications

1. Interrupteur de courant, comportant une matrice de thyristors élémentaires présentant chacun une gâchette de commande, cette matrice comprenant une pluralité d'étages (10, 12, 14, 16, 18) montés en série, chaque étage comprenant une pluralité desdits thyristors montés en parallèle, les anodes des thyristors d'un même étage étant reliées entre elles et les cathodes des thyristors d'un même étage étant reliées entre elles, cet interrupteur comportant en outre des moyens pour délivrer un courant crête de gâchette de chaque thyristor supérieur au 1/3 du courant nominal moyen dans le thyristor.

2. Interrupteur selon la revendication 1, les étages de thyristors étant reliés entre eux par des pistes électriquement conductrices (20, 22, 24, 26).

3. Interrupteur selon la revendication 2, la largeur des pistes conductrices étant au moins égale à 4 mm.

4. Interrupteur selon l'une des revendications 1 à 3, le premier et le dernier étages (10, 18) de thyristors étant reliés chacun à une piste électriquement conductrice (19, 27).

5. Interrupteur selon la revendication 4, la largeur des pistes conductrices auxquelles sont reliées les premier et dernier étages de thyristors étant au moins égale à 10 mm.

6. Interrupteur selon l'une des- revendications 1 à 5 permettant de laisser passer des impulsions de courant positives, comportant en outre des moyens (50) pour bloquer des impulsions de courant négatives.

7. Interrupteur selon la revendication 6, la matrice de thyristors étant en série avec une diode (50) ou un assemblage de diodes.

8. Interrupteur selon l'une des revendications 1 à 5, permettant de laisser passer des impulsions de courant dites positives, comportant en outre des moyens (54, 57, 59, 61) pour laisser passer des impulsions de courant négatives.

9. Interrupteur selon la revendication 8, comportant en outre une diode (54), ou une matrice de diodes, montée en parallèle à la matrice de thyristor et en inverse par rapport à celle-ci.

10. Interrupteur selon la revendication 8, chaque thyristor de la matrice étant muni d'une diode (57, 59, 61) montée en parallèle au thyristor et en inverse par rapport à celui-ci.

## Patentansprüche

1. Stromschalter, eine Matrix elementarer Thyristoren umfassend, von denen jeder ein Steuergate hat, wobei diese Matrix eine Vielzahl in Serie geschalteter Stufen (10, 12, 14, 16, 18) umfasst, jede Stufe eine Vielzahl der genannten, parallelgeschalteten Thyristoren enthält, die Anoden der Thyristoren einer selben Stufe miteinander verbunden sind und die Katoden der Thyristoren einer selben Stufe miteinander verbunden sind und dieser Schalter außerdem Einrichtungen umfasst, die einen Steuergate-Spitzenstrom jedes Thyristors liefern, der höher ist als 1/3 des mittleren Nominalstroms in dem Thyristor.

2. Schalter nach Anspruch 1, bei dem die Thyristorenstufen durch elektrische Leiterbahnen (20, 22, 24, 26) miteinander verbunden sind.

3. Schalter nach Anspruch 2, bei dem die Breite der Leiterbahnen mindestens 4 mm beträgt.

4. Schalter nach einem der Ansprüche 1 bis 3, bei dem auch die erste und die letzte Thyristorenstufe (10, 18) jeweils mit einer elektrischen Leiterbahn (19, 27) verbunden ist.

5. Schalter nach Anspruch 4, bei dem die Breite der Leiterbahnen, mit denen die erste und die letzte Stufe verbunden sind, wenigstens 10 mm beträgt.

6. Schalter nach einem der Ansprüche 1 bis 5, der ermöglicht, positive Stromimpulse durchzulassen und der außerdem Einrichtungen (50) zum Sperren der negativen Stromimpulse umfasst.

7. Schalter nach Anspruch 6, bei die Thyristoren-Matrix in Serie geschaltete ist mit einer Diode (50) oder einer Diodenanordnung.

8. Schalter nach einem der Ansprüche 1 bis 5, der ermöglicht, positive Stromimpulse durchzutassen und der außerdem Einrichtungen (54, 57, 59, 61) umfasst, um negative Stromimpulse durchzulassen.

9. Schalter nach Anspruch 8, der außerdem eine Diode (54) oder eine Diodenmatrix umfasst, die parallel zu der Thyristormatrix und in Umkehrrichtung zu dieser geschaltet ist.

10. Schalter nach Anspruch 8, wobei jeder Tyristor der Matrix mit einer Diode (57, 59, 61) versehen ist, die parallel zum Thyristor und in Umkehrrichtung zu diesem geschaltet ist.

## Claims

1. Current switch, comprising a matrix of elementary thyristors each having a control trigger, this matrix comprising a plurality of stages (10, 12, 14, 16, 18) mounted in series, with each stage comprising a plurality of said thyristors mounted in parallel, the thyristor anodes of one stage being linked to each other, and the thyristor cathodes of one stage being linked to each other, this switch comprising, in addition, means to deliver a peak value current from the trigger of each thyristor greater than 1/3 of the average nominal current in the thyristor.

2. Switch according to claim 1, the stages of the thyristors being linked to each other by electrically conductive tracks (20, 22, 24, 26).

3. Switch according to claim 2, the size of the conductive tracks being at least equal to 4mm.

4. Switch according to one of claims 1 to 3, the first and the last stages (10, 18) of the thyristors each being linked to an electrically conductive track (19, 27).

5. Switch according to claim 4, the size of the conductive tracks to which the first and last stages of the thyristors are linked being at least equal to 10mm.

6. Switch according to one of claims 1 to 5, allowing positive current pulses to pass, comprising, in addition, means (50) to block negative current pulses.

7. Switch according to claim 6, the thyristor matrix being in series with a diode (50) or a diode assembly.

8. Switch according to one of claims 1 to 5, allowing so called positive current pulses to pass, comprising, in addition, means (54, 57, 59, 61) to allow negative current pulses to pass.

9. Switch according to claim 8 comprising, in addition, a diode (54) or a matrix of diodes, mounted in parallel to the thyristor matrix and in reverse relative to the latter.

10. Switch according to claim 8, each thyristor of the matrix being provided. with a diode (57, 59, 61) mounted parallel to the thyristor and inverse relative to the latter.
